# EUROPEAN PATENT APPLICATION

(11) **EP 4 790 786 A1**
(43) Date of publication of application: **12.08.2026**
(21) Application number: 24886301.1
(22) Date of filing: 31.10.2024
(51) Int. Cl.: H01M 10/42, H01M 50/247, H01M 10/48, H04M 1/02, H05K 1/14, H05K 1/18, H01M 50/287, H01M 50/50

(54) **BATTERY AND ELECTRONIC DEVICE COMPRISING SAME**

(30) Priority: 31.10.2023 KR 20230148131; 18.01.2024 KR 20240008228
(71) Applicant: Samsung Electronics Co., Ltd., Suwon-si, Gyeonggi-do 16677 (KR)
(72) Inventor: LEE, Jinwoo, Suwon-si Gyeonggi-do 16677 (KR); LEE, Seunghwan, Suwon-si Gyeonggi-do 16677 (KR); KANG, Byunggi, Suwon-si Gyeonggi-do 16677 (KR); LIM, Gun, Suwon-si Gyeonggi-do 16677 (KR); CHOI, Taihwan, Suwon-si Gyeonggi-do 16677 (KR)
(74) Representative: Gulde & Partner
(86) International application number: PCT/KR2024/016928
(87) International publication number: WO 2025/095629

(57) **Abstract**

An electronic device according to an embodiment of the present disclosure may comprise: a housing; a battery pack disposed in the housing, the battery pack comprising a battery cell and a battery protective circuit module (PCM) disposed so as to contact a surface of the battery cell, the battery PCM comprising a first connecting portion having at least one hole formed therein; a circuit board having at least one second hole formed therein, the circuit board being disposed so as to overlap at least a part of the battery PCM; and at least one retaining member configured to extend through the at least one first hole and the at least one second hole such that the battery PCM and the circuit board are retained on the housing.

## Description

### [Technical Field]

Various embodiments of the disclosure relate to an electronic device, e.g., a battery and an electronic device including the same.

### [Background Art]

With the remarkable advancement of information and communication technology and semiconductor technology, the distribution and use of various electronic devices are rapidly increasing. Recent electronic devices are being developed to be portable and capable of communication.

An electronic device may refer to a device that performs a specific function according to a mounted program, such as home appliances, electronic organizers, portable multimedia players, mobile communication terminals, tablet PCs, video/audio devices, desktop/laptop computers, or vehicle navigation systems. For example, such electronic devices may output stored information as audio or video. As the integration density of electronic devices increases and ultra-high-speed, high-capacity wireless communication becomes common, recently, various functions may be mounted on a single electronic device such as a mobile communication terminal. For example, not only a communication function but also an entertainment function such as a game, a multimedia function such as music/video playback, a communication and security function such as mobile banking, and a function such as schedule management or electronic wallet are being integrated into a single electronic device. Such electronic devices are being downsized so that a user may conveniently carry them.

The above-described information may be provided as related art for the purpose of helping understanding of the disclosure. No claim or determination is made as to whether any of the foregoing is applicable as prior art in relation to the disclosure.

### [Detailed Description of the Invention]

### [Technical Solution]

An electronic device according to an embodiment of the disclosure may include a housing, a battery pack disposed in the housing and including a battery cell and a battery protection circuit module (protective circuit module (PCM)) including a first connecting portion disposed to be in contact with a surface of the battery cell, wherein at least one first hole is formed at the first connecting portion, a circuit board disposed to overlap with at least part of the battery protection circuit module, wherein at least one second hole is formed at the circuit board, and at least one fixing member configured to penetrate through the at least one first hole and the at least one second hole to fix the battery protection circuit module and the circuit board to the housing. An electronic device according to an embodiment of the disclosure may include a housing, a battery pack disposed in the housing and including a battery cell and a battery protection circuit module (protective circuit module (PCM)) including a first connecting portion disposed to be in contact with a surface of the battery cell, wherein at least one first hole is formed at the first connecting portion, a circuit board disposed to overlap with at least part of the battery protection circuit module, wherein at least one second hole is formed at the circuit board, and at least one fixing member configured to penetrate through the at least one first hole and the at least one second hole to fix the battery protection circuit module and the circuit board to the housing. The first connecting portion may include at least one pad disposed on a surface of the first connecting portion in contact with the circuit board and electrically connected to at least part of the circuit board.

A battery pack according to an embodiment of the disclosure may include a battery cell and a battery protection circuit module (PCM) 320 including a first connecting portion 321 disposed to be in contact with a surface of the battery cell, wherein at least one first hole 322 is formed at the first connecting portion 321. The first connecting portion may include at least one pad 350 electrically connected to at least part of the circuit board.

### [Brief Description of Drawings]

The above-described aspects or other aspects, configurations and/or advantages of an embodiment of the disclosure may become clearer through the following detailed description with reference to the accompanying drawings.
FIG. 1 is a block diagram of an electronic device in a network environment according to an embodiment.
FIG. 2 is a perspective view illustrating a front surface of an electronic device according to an embodiment of the disclosure.
FIG. 3 is a rear perspective view illustrating the electronic device of FIG. 2 according to an embodiment of the disclosure.
FIG. 4A is a front exploded perspective view illustrating the electronic device of FIG. 2 according to an embodiment of the disclosure.
FIG. 4B is a rear exploded perspective view illustrating the electronic device of FIG. 2 according to an embodiment of the disclosure.
FIG. 5 is an exploded perspective view of a housing, a battery pack, and a circuit board according to embodiments of the disclosure.
FIG. 6A is a view illustrating a battery pack viewed from various directions according to embodiments of the disclosure.
FIG. 6B is a view illustrating a battery pack according to embodiments of the disclosure.
FIG. 7 is an enlarged view illustrating a first connecting portion according to embodiments of the disclosure.
FIG. 8 is a view illustrating an assembled state of a circuit board, a battery pack, and a housing viewed from above according to embodiments of the disclosure.
FIG. 9 is a cross-sectional view of FIG. 8 taken along line A-A' according to an embodiment of the disclosure.

Throughout the accompanying drawings, similar reference numerals may be assigned to similar parts, configurations, and/or structures.

### [Mode for Carrying out the Invention]

The electronic device according to embodiments of the disclosure may be one type of device. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include a modification, equivalent, or substitute of the embodiment. In connection to the description of the drawings, similar reference numerals may be used for similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

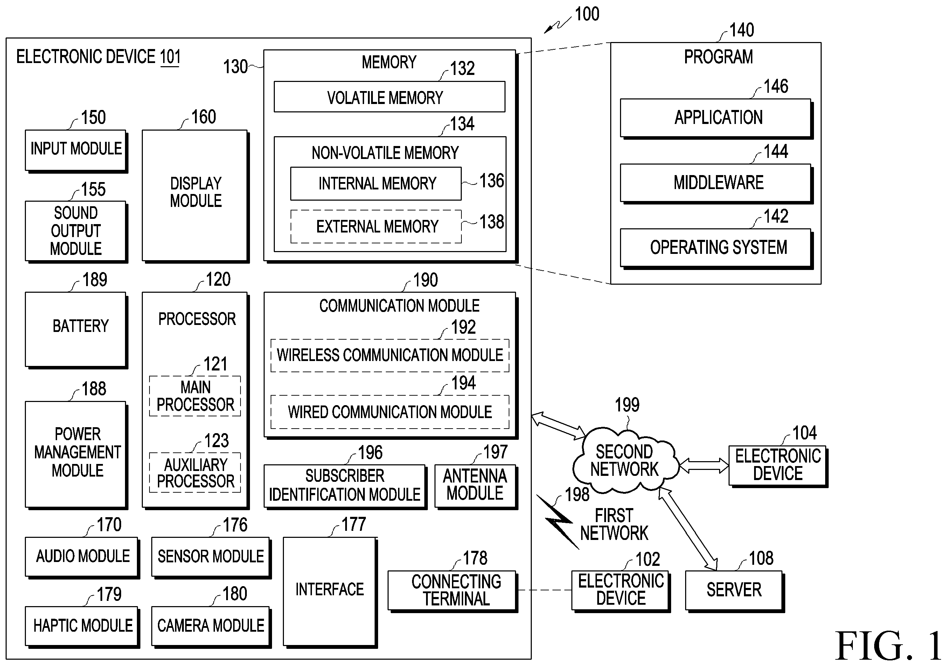

FIG. 1 is a block diagram illustrating an electronic device in a network environment according to an embodiment disclosed herein.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store a piece of data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., the electronic device 102) directly (e.g., wiredly) or wirelessly coupled with the electronic device 101.

The sensor module 176 may detect an operation state (e.g., power or temperature) of the electronic device 101 or an external environmental state (e.g., the user's state), and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wiredly) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wiredly) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support a requirement specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

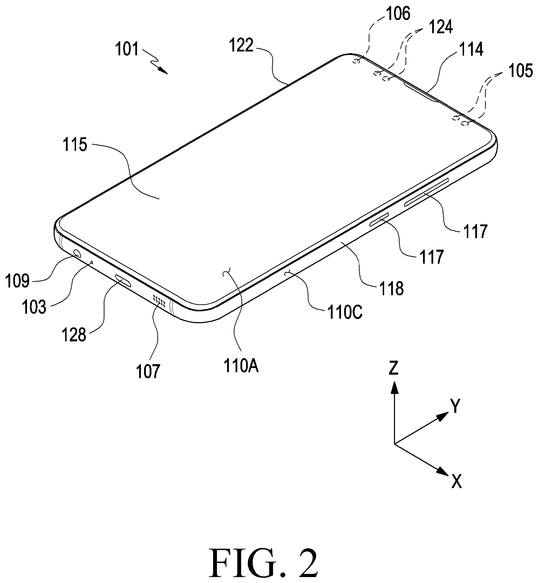

FIG. 2 is a front perspective view illustrating an electronic device 101 according to an embodiment of the disclosure.

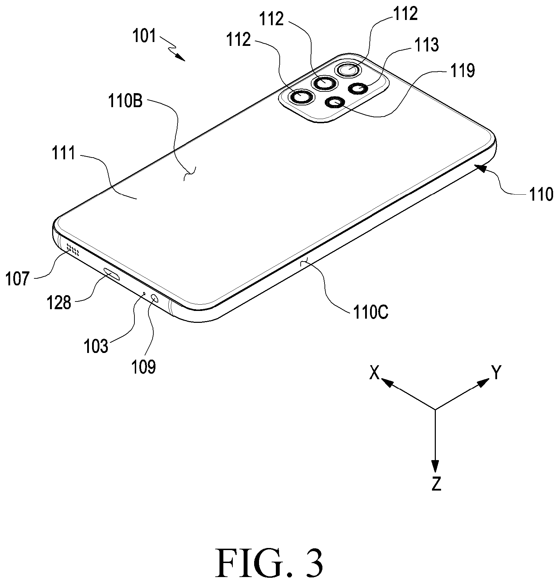

FIG. 3 is a rear perspective view illustrating the electronic device 101 of FIG. 2 according to an embodiment of the disclosure.

Referring to FIGS. 2 and 3, according to an embodiment, an electronic device 101 (e.g., the electronic device 101 of FIG. 1) may include a housing 110 including a first surface (or front surface) 110A, a second surface (or rear surface) 110B, and a side surface 110C surrounding a space between the first surface 110A and the second surface 110B. According to an embodiment (not shown), the housing 110 may denote a structure forming the first surface 110A of FIG. 2, the second surface 110B of FIG. 3, and some of the side surfaces 110C.

According to an embodiment, the first surface 110A may be formed, at least in part, by a substantially transparent front plate 122 (e.g., a glass plate including various coating layers, or a polymer plate). The second surface 110B may be formed of a substantially opaque rear plate 111. The rear plate 111 may be formed of, e.g., laminated or colored glass, ceramic, polymer, metal (e.g., aluminum, stainless steel (STS), or magnesium), or a combination of at least two thereof. The side surface 110C may be formed by a side structure (or a "side bezel structure") 118 that couples to the front plate 122 and the rear plate 111 and includes a metal and/or polymer. In an embodiment, the rear plate 111 and the side structure 118 may be integrally formed together and include the same material (e.g., a metal, such as aluminum).

According to an embodiment, the front plate 122 may include area(s) that bend from at least a portion of an edge toward the rear plate 111 and seamlessly extend. For example, only one of the areas of the front plate 122 (or the rear plate 111), which bend to the rear plate 111 (or front plate 122) and extend may be included in one edge of the first surface 110A. According to an embodiment, the front plate 122 or rear plate 111 may be substantially flat and, in this case, may not include an area bending and extending. When an area bending and extending is included in the front plate 122 or rear plate 111, the thickness of the electronic device 101 at the portion including the area bending and extending may be smaller than the thickness of the rest.

According to an embodiment, the electronic device 101 may include at least one of a display 115, an audio module (e.g., the microphone hole 103, the external speaker hole 107, and the phone receiver hole 114), a sensor module (e.g., the first sensor module 124, the second sensor module (not illustrated), or the third sensor module 119), a camera module (e.g., the first camera device 105, the second camera device 112, or the flash 113), a key input device 117, a light emitting device 106, and a connector hole (e.g., the first connector hole 128 or the second connector hole 109). In an embodiment, the electronic device 101 may exclude at least one (e.g., the key input device 117 or the light emitting device 106) of the components or may add other components.

The display 115 may output a screen or be visually exposed through a significant portion of the first surface 110A (e.g., the front plate 122), for example. In an embodiment, at least a portion of the display 115 may be visually exposed through the front plate 122 forming the first surface 110A, or through a portion of the side surface 110C. In an embodiment, an edge of the display 115 may be formed to be generally the same as an adjacent outer shape of the front plate 122. In an embodiment (not illustrated), the interval between the outer edge of the display 115 and the outer edge of the front plate 122 may remain substantially even to give a larger area of visual exposure of the display 115.

According to an embodiment, a recess or an opening may be formed at a portion of the screen display area of the display 115, and there may be included at least one of an audio module (e.g., the phone receiver hole 114), a sensor module (e.g., the first sensor module 124), a camera module (e.g., the first camera device 105), and a light emitting device 106 that are aligned with the recess or the opening. In an embodiment (not shown), at least one of the audio module (e.g., the phone receiver hole 114), sensor module (e.g., the first sensor module 124), camera module (e.g., the first camera device 105), fingerprint sensor (not shown), and light emitting device 106 may be included on the rear surface of the screen display area of the display 115. In an embodiment (not illustrated), the display 115 may be disposed to be coupled with, or adjacent, a touch detecting circuit, a pressure sensor capable of measuring the strength (pressure) of touches, and/or a digitizer for detecting a magnetic field-type stylus pen.

According to an embodiment, the audio modules 103, 107, and 114 may include a microphone hole 103 and speaker holes (e.g., the external speaker hole 107 and the phone receiver hole 114). A microphone for acquiring external sounds may be disposed in the microphone hole 103. In an embodiment, a plurality of microphones may be disposed to detect the direction of the sound. The speaker holes may include an external speaker hole 107 and a phone receiver hole 114. According to an embodiment, the speaker holes (e.g., the external speaker hole 107 and the phone receiver hole 114) and the microphone hole 103 may be implemented as a single hole, or speakers may be included without the speaker holes (e.g., the external speaker hole 107 and the phone receiver hole 114) (e.g., piezo speakers).

According to an embodiment, the sensor module may generate an electrical signal or data value corresponding to an internal operation state of the electronic device 101 or an external environmental state. The sensor modules may include a first sensor module 124 (e.g., a proximity sensor) and/or a second sensor module (not shown) (e.g., a fingerprint sensor) disposed on the first surface 110A of the housing 110 and/or a third sensor module 119 disposed on the second surface 110B of the housing 110. The second sensor module (not shown) (e.g., a fingerprint sensor) may be disposed on the second surface 110B or side surface 110C as well as the surface 110A (e.g., the display 115) of the housing 110. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 124.

According to an embodiment, the camera modules may include a first camera device 105 disposed on the first surface 110A of the electronic device 101, and a second camera device 112 and/or a flash 113 disposed on the second surface 110B. The camera devices (e.g., the first camera device 105 and the second camera device 112) may include one or more lenses, an image sensor, and/or an image signal processor. The flash 113 may include, e.g., a light emitting diode or a xenon lamp. In an embodiment, one or more lenses (an infrared (IR) camera, a wide-angle lens, and a telephoto lens) and image sensors may be disposed on a surface of the electronic device 101. In an embodiment, flash 113 may emit infrared light. The infrared light emitted by the flash 113 and reflected by the subject may be received through the third sensor module 119. The electronic device 101 or the processor (e.g., the processor 120 of FIG. 1) of the electronic device 101 may detect depth information about the subject based on the time point when the infrared light is received from the third sensor module 119.

According to an embodiment, the key input device 117 may be disposed on the side surface 110C of the housing 110. In an embodiment, the electronic device 101 may not include some or all of the above-mentioned key input device 117, and the key input device 117 not included may be implemented in another form such as a soft key on the display 115. In an embodiment, the key input device may include the sensor module disposed on the second surface 110B of the housing 110.

According to an embodiment, the light emitting device 106 may be disposed on the first surface 110A of the housing 110, for example. The light emitting device 106 may provide, e.g., information about the state of the electronic device 101 in the form of light. In an embodiment, the light emitting device 106 may provide a light source that interacts with, e.g., the camera module (e.g., the first camera device 105). The light emitting device 106 may include, e.g., a light emitting diode (LED), an infrared (IR) LED, or a xenon lamp.

According to an embodiment, the connector holes (e.g., the first connector hole 128 or the second connector hole 109) may include, e.g., a first connector hole 128 for receiving a connector (e.g., a USB connector) for transmitting/receiving power and/or data to/from an external electronic device (e.g., the electronic device 1002 of FIG. 1) and/or a second connector hole 109 (e.g., an earphone jack) for receiving a connector for transmitting/receiving audio signals to/from the external electronic device.

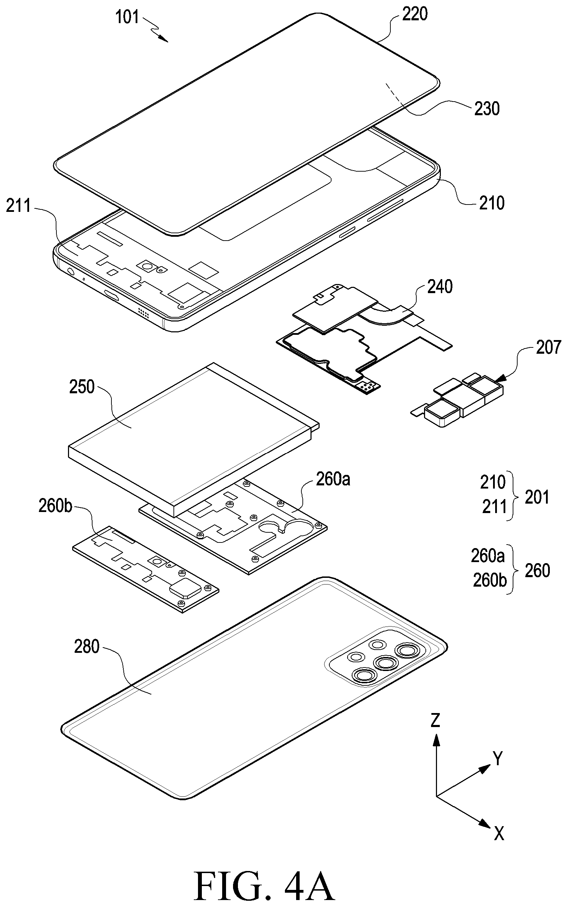

FIG. 4A is a front exploded perspective view illustrating the electronic device 101 of FIG. 2 according to an embodiment of the disclosure.

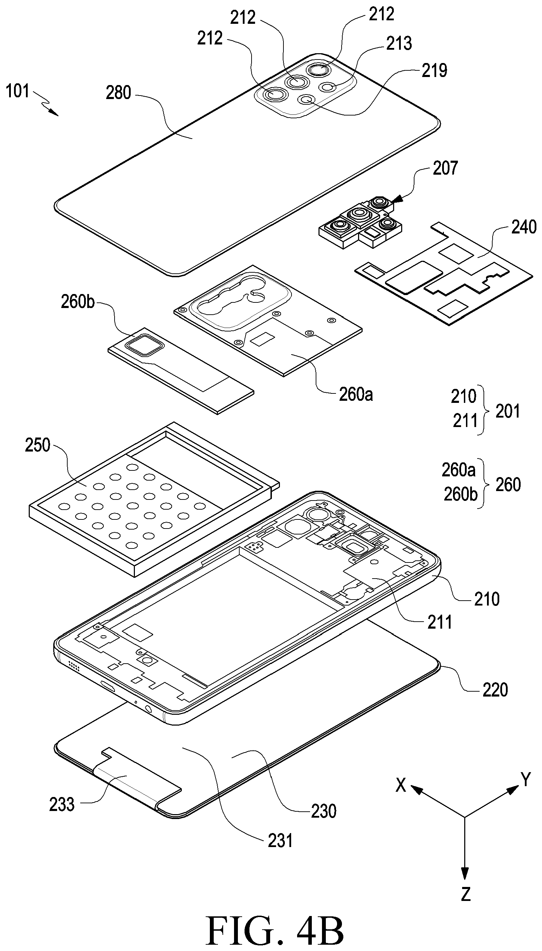

FIG. 4B is a rear exploded perspective view illustrating the electronic device 101 of FIG. 2 according to an embodiment of the disclosure.

Referring to FIGS. 4A and 4B, an electronic device 101 (e.g., the electronic device 101 of FIG. 1, 2, or 3) may include a side structure 210, a first supporting member 211 (e.g., a bracket), a front plate 220 (e.g., the front plate 122 of FIG. 2), a display 230 (e.g., the display 115 of FIGS. 2 and 3), a printed circuit board (or a board assembly) 240, a battery 250, a second supporting member 260 (e.g., a rear case), an antenna, a camera assembly 207, and a rear plate 280 (e.g., the rear plate 111 of FIG. 3).

According to an embodiment, the electronic device 101 may exclude at least one (e.g., the first supporting member 211 or the second supporting member 260) of the components or may add other components. At least one of the components of the electronic device 101 may be the same or similar to at least one of the components of the electronic device 101 of FIG. 2 or 3 and no duplicate description is made below.

According to an embodiment, the first supporting member 211 may be disposed inside the electronic device 101 to be connected with the side structure 210 or integrated with the side structure 210. The first supporting member 211 may be formed of, e.g., a metallic material and/or non-metallic material (e.g., polymer). When at least partially formed of a metallic material, a portion of the side structure 210 or the first supporting member 211 may function as an antenna. The display 230 may be joined onto a surface of the first supporting member 211, and the printed circuit board 240 may be joined onto the opposite surface of the first supporting member 211. A processor (e.g., the processor 120 of FIG. 1), memory (e.g., the memory 130 of FIG. 1), and/or an interface (e.g., the interface 177 of FIG. 1) may be mounted on the printed circuit board 240. The processor may include one or more of, e.g., a central processing unit, an application processor, a graphic processing device, an image signal processor, a sensor hub processor, or a communication processor.

According to an embodiment, the first supporting member 211 and the side structure 210 may be collectively referred to as a front case or a housing 201. According to an embodiment, the housing 201 may be generally understood as a structure for receiving, protecting, or disposing the printed circuit board 240 or the battery 250. In an embodiment, the housing 201 may be understood as including a structure that the user may visually or tactfully recognize from the outside of the electronic device 101, e.g., the side structure 210, the front plate 220, and/or the rear plate 280. In an embodiment, the 'front or rear surface of the housing 201' may mean the first surface 110A of FIG. 2 or the second surface 110B of FIG. 3. In an embodiment, the first supporting member 211 may be disposed between the front plate 220 (e.g., the first surface 110A of FIG. 2) and the rear plate 280 (e.g., the second surface 110B of FIG. 3) and may function as a structure for placing an electrical/electronic component, such as the printed circuit board 240 or the camera assembly 207.

According to an embodiment, the display 230 may include a display panel 231 and a flexible printed circuit board 233 extending from the display panel 231. It may be understood that the flexible printed circuit board 233 is, e.g., electrically connected to the display panel 231 while at least partially disposed on the rear surface of the display panel 231. In an embodiment, reference number '231' may be understood as a protective sheet disposed on the rear surface of the display panel. For example, the protective sheet may be understood as a portion of the display panel 231 unless otherwise designated in the detailed description below. In an embodiment, the protective sheet may function as a cushioning structure that absorbs external force (e.g., a low-density elastic material, such as a sponge) or an electromagnetic shielding structure (e.g., a copper sheet (CU sheet)). According to an embodiment, the display 230 may be disposed on the inner surface of the front plate 220 and, by including a light emitting layer, output a screen through at least a portion of the front plate 220 or the first surface 110A of FIG. 2. As mentioned above, the display 230 may output substantially the entire area of the front plate 220 or the first surface 110A of FIG. 2.

According to an embodiment, the memory may include, e.g., a volatile memory or a non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect the electronic device 101 to an external electronic device, e.g., and may include a USB connector, an SD card/MMC connector, or an audio connector.

According to an embodiment, the second supporting member 260 may include, e.g., an upper supporting member 260a and a lower supporting member 260b. In an embodiment, the upper supporting member 260a, together with a portion of the first supporting member 211, may be disposed to surround the printed circuit board 240. A circuit device (e.g., a processor, a communication module, or memory) implemented in the form of an integrated circuit chip or various electrical/electronic components may be disposed on the printed circuit board 240. According to an embodiment, the printed circuit board 240 may receive an electromagnetic shielding environment from the upper supporting member 260a. In an embodiment, the lower supporting member 260b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). In this case, the lower supporting member 260b, together with the other part of the first supporting member 211, may be disposed to surround the additional printed circuit board. A speaker module or interface disposed on an additional printed circuit board (not shown) or lower supporting member 260b may be disposed corresponding to the connector hole (e.g., the first connector hole 128 or the second connector hole 109) or the audio module (e.g., the microphone hole 103 or the speaker hole (e.g., the external speaker hole 107 or the phone receiver hole 114)) of FIG. 2.

According to an embodiment, the battery 250 may be a device for supplying power to at least one component of the electronic device 101, and may include, e.g., a primary cell which is not rechargeable, a secondary cell which is rechargeable, or a fuel cell. At least a portion of the battery 250 may be disposed on substantially the same plane as the printed circuit board 240. The battery 250 may be integrally disposed inside the electronic device 101 or may be disposed to be detachable from the electronic device 101.

Although not shown, the antenna may include a conductor pattern implemented on the surface of the second supporting member 260 through, e.g., laser direct structuring. In an embodiment, the antenna may include a printed circuit pattern formed on the surface of the thin film. The thin film-type antenna may be disposed between the rear plate 280 and the battery 250. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 210 and/or the first supporting member 211.

According to an embodiment, the camera assembly 207 may include at least one camera module. Inside the electronic device 101, the camera assembly 207 may receive at least a portion of the light incident through the optical hole or the camera windows 212, 213, and 219. In an embodiment, the camera assembly 207 may be disposed on the first supporting member 211 in a position adjacent to the printed circuit board 240. In an embodiment, the camera module(s) of the camera assembly 207 may be generally aligned with either one of the camera windows 212, 213, and 219 and be at least partially surrounded by the second supporting member 260 (e.g., the upper supporting member 260a).

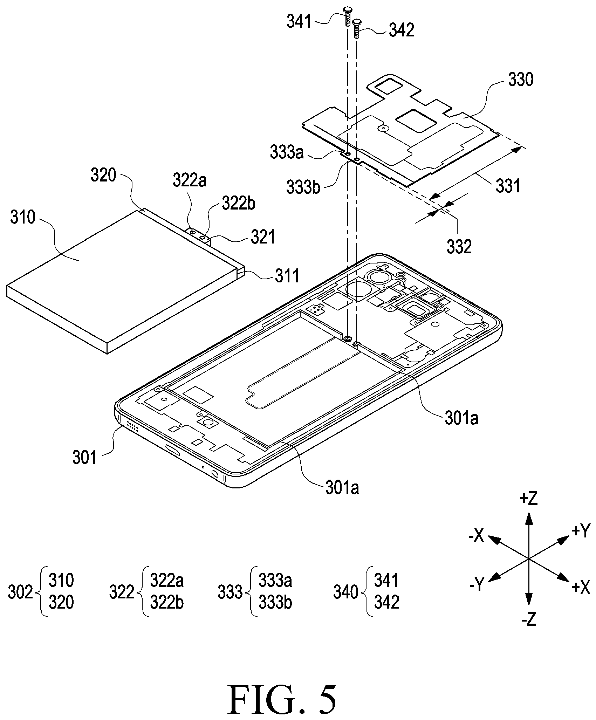

FIG. 5 is an exploded perspective view of a housing 301, a battery pack 302, and a circuit board 330 according to embodiments of the disclosure.

Referring to FIG. 5, an electronic device 101 may include a housing 301, a battery pack 302 disposed in the housing 301, a circuit board 330, and at least one fixing member 340 connecting and/or fixing the circuit board 330 and the battery pack 302. The configuration of the housing 301, the battery pack 302, and the circuit board 330 of FIG. 5 may be entirely or partially identical to the configuration of the housing 110, the battery pack 250, and the circuit board 240 of FIGS. 2 to 4B. The embodiment of FIG. 5 may be partially combined with the embodiment of FIGS. 2 to 4B.

According to an embodiment, the battery pack 302 may be disposed in the housing 301. According to an embodiment, the battery pack 302 may be disposed on the housing 301 (e.g., the first supporting member 211 of FIG. 4B). In an embodiment, the housing 301 may include a guide rib or partition 301a at least surrounding and/or defining a space accommodating the battery pack 302. In an embodiment, the guide rib or partition 301a may protrude from a surface of the first supporting member 211 (e.g., a surface facing the +Z axis direction) and may be formed to at least partially surround a side of the battery pack 302. For example, the guide rib or partition 301a may prevent structures or electrical/electronic components disposed around from directly contacting the battery pack 302 by at least partially separating a space in which the battery pack 302 is disposed from other spaces.

According to an embodiment, the battery pack 302 may include a battery cell 310 and a battery protection circuit module 320 (protective circuit module (PCM)) for protecting the battery cell 310 from overvoltage, overcurrent, and over-discharge. The battery pack 302 may include an enclosure or shell, and the battery cell 310 and the battery protection circuit module 320 may be disposed in an internal space of the enclosure or shell. According to an embodiment, the battery protection circuit module 320 may include a battery protection circuit and a board on which the battery protection circuit is mounted. For example, the board on which the battery protection circuit is mounted may be a rigid board. According to an embodiment, the first connecting portion 321 may be the battery protection circuit itself. According to an embodiment, at least a portion of the first connecting portion 321 may be electrically connected to the battery protection circuit. For example, the first connecting portion 321 may be at least partially made of a rigid material.

According to an embodiment, the battery cell 310 may be configured to store power or be rechargeable. For example, the battery cell 310 may have a rectangular shape.

According to an embodiment, the battery protection circuit module 320 may perform a function of changing an interface for connecting the battery cell 310 to the electronic device 101, and monitoring current and voltage flowing between the circuit board 330 and the battery cell 310, and detecting an abnormal change in current and voltage flowing from the circuit board 330 to the battery cell 310 to protect the battery cell 310. For example, the battery protection circuit module 320 may perform a function of detecting a cell voltage when the voltage of the battery cell 310 rises due to a charging voltage and current input from the outside, and blocking and releasing so that the cell is not charged above an overcharge voltage set in the module. For example, the battery protection circuit module 320 may perform a function of detecting a cell voltage when the voltage of the cell is gradually discharged due to current consumed to the outside, and blocking and releasing so that the cell is not discharged below an over-discharge voltage set in the module. According to an embodiment, due to an abnormal phenomenon of the electronic device 101 or a charging device, the battery protection circuit module 320 may perform a function of blocking and releasing charging and discharging current so that the charging and discharging current is not charged or discharged above an overcurrent set in the module. According to an embodiment, when + and - terminals are short-circuited outside the battery pack 302, a current of approximately 20 times the capacity of the battery cell 310 instantaneously flows, and the battery protection circuit module 320 may perform a function of preventing an accident and protecting the battery pack 302 by blocking this current.

According to an embodiment, the battery protection circuit module 320 may be designed with a low internal resistance so that the temperature does not rise above a specific temperature even when the current charged to and discharged from the battery cell 310 flows at a maximum value. The low internal resistance may minimize voltage drop during discharge and charge, and may shorten charging time and manage accurate battery capacity.

According to an embodiment, the circuit board 330 may be disposed in the housing 301. According to an embodiment, the battery pack 302 may be disposed on a first supporting member (e.g., the first supporting member 211 of FIG. 4B). According to an embodiment, the circuit board 330 may be disposed such that at least part of the battery protection circuit module 320 is disposed in an upper direction (+Y axis direction). According to an embodiment, the circuit board 330 may be disposed such that at least part thereof is disposed in an upper direction (+Y axis direction) of the battery protection circuit module 320 and at least part thereof overlaps with the battery protection circuit module 320.

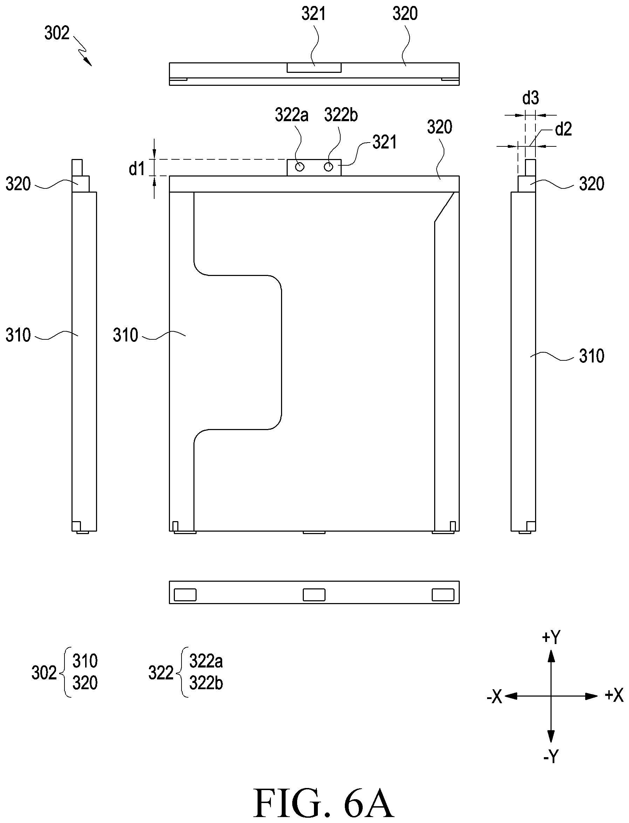

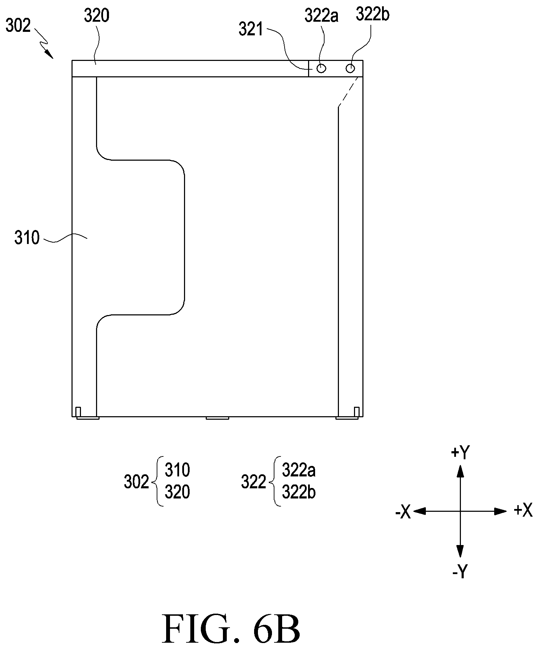

FIG. 6A is a view illustrating a battery pack 302 viewed from various directions according to embodiments of the disclosure. FIG. 6A may include a front view, a top view viewed from the +Y axis, a bottom view viewed from the -Y axis, a side view viewed from the -X axis, and a side view viewed from the +X axis. FIG. 6B is a view illustrating a battery pack according to embodiments of the disclosure.

Referring to FIGS. 6A and 6B, an electronic device 101 may include a housing 301, a battery pack 302 disposed in the housing 301, a circuit board 330, and at least one fixing member 340 connecting and/or fixing the circuit board 330 and the battery pack 302. The configuration of the housing 301, the battery pack 302, the circuit board 330, and the fixing member 340 of FIGS. 6A and 6B may be entirely or partially identical to the configuration of the housing 301, the battery pack 302, the circuit board 330, and the fixing member 340 of FIG. 5. The embodiment of FIGS. 6A and 6B may be partially combined with the embodiment of FIG. 5.

According to an embodiment, the battery protection circuit module 320 may be disposed in an upper direction (e.g., +Y axis direction of FIG. 5) of the battery cell 310. According to an embodiment, the battery protection circuit module 320 may be disposed to be in contact with a first surface (e.g., the first surface 311 of FIG. 5) that is a surface of the battery cell 310 facing the upper direction (e.g., +Y axis direction of FIG. 5). For example, the battery protection circuit module 320 may be formed to extend in the X axis direction in parallel with the first surface 311 of the battery cell 310.

According to an embodiment, the battery protection circuit module 320 may be electrically connected to the battery cell 310 by a method such as welding using a connecting member such as a nickel tap member. The electronic device 101, for example, a processor or a power management module, may be set to receive external power and charge the battery pack 302, or to operate using the power of the battery pack 302 when the external power is not supplied. For example, the battery cell 310 may receive charging power through the battery protection circuit module 320 and/or the circuit board 330, or may provide power for operating the electronic device 101.

According to an embodiment, the battery pack 302 may include a bonding member (not shown) attaching the battery protection circuit module 320 to the battery cell 310. The bonding member may include, for example, a double-sided tape or an elastic body (e.g., a sponge with an adhesive material applied on both sides), and the battery protection circuit module 320 may be attached to a first surface that is one side surface of the battery cell 310 by the bonding member. The battery protection circuit module 320 may be accommodated into the inside of the enclosure or shell while being coupled to the battery cell 310. When the bonding member is made of an elastic body, the bonding member may function as a shock absorbing member between the battery cell 310 and the battery protection circuit module 320.

According to an embodiment, the battery protection circuit module 320 may include a first connecting portion 321 in which at least one first hole 322 is formed and which is disposed to overlap with at least part of the circuit board 330. The first connecting portion 321 may be made of a rigid material. The battery protection circuit module 320 may be electrically connected to the circuit board 330 through the first connecting portion 321. The first connecting portion 321 may electrically connect the battery protection circuit module 320 to the circuit board 330, and may fix the position of the battery protection circuit module 320 relative to the housing 301 and the circuit board 330. According to an embodiment, the battery protection circuit module 320 may be connected to the circuit board 330 through the first connecting portion 321 without using a flexible printed circuit board (FPCB) and/or a connector, thereby solving a crack occurring when bending the flexible printed circuit board (FPCB) in the manufacturing process, and a product defect problem occurring due to inaccurate positioning when fastening a connector. By removing a resistance (DCR) occupied by the flexible printed circuit board (FPCB), charging time may be shortened by approximately 5 minutes, and heat dissipation performance of the battery protection circuit module 320 may be improved.

According to an embodiment, referring to FIG. 6A, the first connecting portion 321 may protrude from an upper surface of the battery protection circuit module 320 in an upper direction (e.g., +Y axis direction of FIG. 5). For example, the first connecting portion 321 may protrude from the upper surface of the battery protection circuit module 320 in the upper direction (+Y axis direction) by a first length d1. The first length d1 may be changeable depending on a connection signal strength and number with the circuit board 330. For example, the first connecting portion 321 may be formed at a central portion of the battery protection circuit module 320 based on the X axis direction. For example, the thickness d3 of the first connecting portion 321 in the Z axis direction may be thinner than the thickness d2 of the battery protection circuit module 320. However, the shape and arrangement of the first connecting portion 321 are not limited by the above embodiment and may be variously modified as long as the battery protection circuit module 320 is fixed to the housing 301 and the circuit board 330.

According to an embodiment, referring to FIG. 6B, the first connecting portion 321 may be substantially the same portion as at least a portion of the battery protection circuit 320. For example, at least a portion of the battery protection circuit module 320 may be disposed to overlap with the circuit board 330 and function as the first connecting portion 321 electrically connected to the circuit board 330. For example, the first connecting portion 321 may be formed at an edge portion of the battery protection circuit module 320 based on the X axis direction. According to an embodiment, in this case, the second area (e.g., 332 of FIG. 5) of the circuit board 330 may be an area protruding in a lower direction (-Y axis direction) to be disposed to overlap with at least part of the battery protection circuit module 320.

According to an embodiment, the first connecting portion 321 may include at least one first hole 322. For example, the at least one first hole 322 may include a 1-1 hole 322a located in a left direction (-X axis direction) of the first connecting portion 321 and a 1-2 hole 322b located in a right direction (+X axis direction) of the first connecting portion 321. For example, the 1-1 hole 322a and the 1-2 hole 322b may be arranged side by side. The at least one first hole 322 may be a configuration for stable coupling between at least one terminal formed on the first connecting portion 321 and the circuit board 330, and for fixing the position of the battery protection circuit module 320. However, the size and number of the at least one first hole 322 are not limited by the above embodiment and may be variously modified.

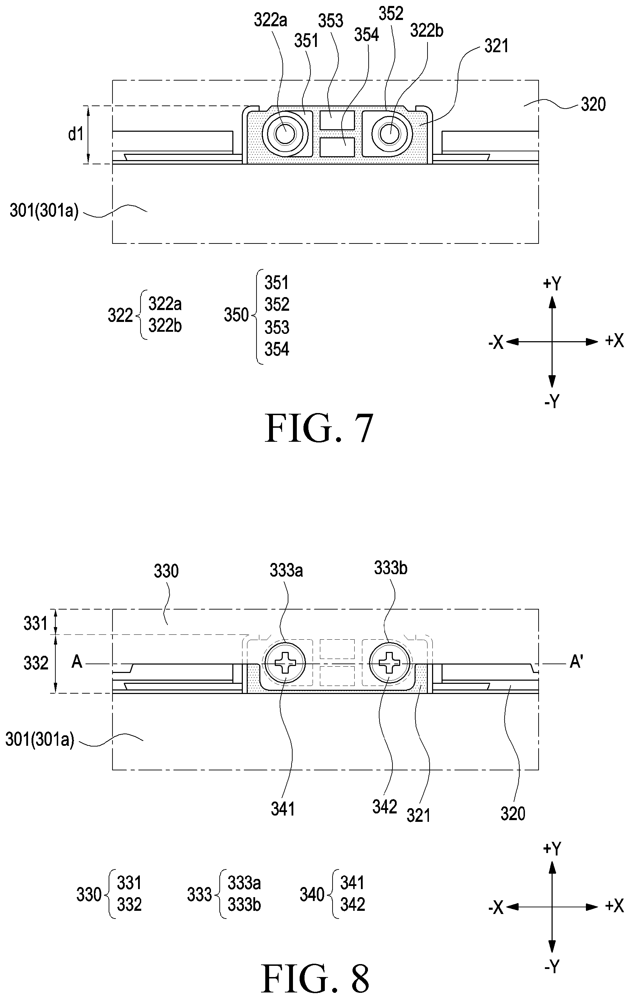

FIG. 7 is an enlarged view illustrating a first connecting portion according to embodiments of the disclosure.

Referring to FIG. 7, an electronic device 101 may include a housing 301, a battery pack 302 disposed in the housing 301, a circuit board 330, and at least one fixing member 340 connecting and/or fixing the circuit board 330 and the battery pack 302. The configuration of the housing 301, the battery pack 302, the circuit board 330, and the fixing member 340 of FIG. 7 may be entirely or partially identical to the configuration of the housing 301, the battery pack 302, the circuit board 330, and the fixing member 340 of FIGS. 6A and 6B. The embodiment of FIG. 7 may be partially combined with the embodiment of FIGS. 6A and 6B.

According to an embodiment, at least one pad 350 may be disposed on a front surface (a surface facing the +Z axis direction) of the first connecting portion 321. According to an embodiment, the at least one pad 350 may include, for example, an integrated circuit chip on which a charging protection circuit is mounted, and may further include a passive element and/or an active element. According to an embodiment, the at least one pad 350 may be a tab or a conductive pad to which lead(s) extending from the battery protection circuit module 320 are connected or contacted. For example, the at least one pad 350 may be an electrically conductive material and may be positioned on the battery protection circuit module 320 through a surface mounting technology (SMT) process. For example, the at least one pad 350 may be a metal pad to which solder paste is applied in the surface mounting technology process.

According to an embodiment, the at least one pad 350 may be, for example, four pads. The at least one pad 350 may include at least one of a first pad 351 connecting a VBAT signal, a second pad 352 connecting a GND signal, a third pad 353 connecting a P-Sense signal, and a fourth pad 354 connecting an ID signal. According to an embodiment, the first pad 351 may be provided as a first power terminal. The second pad 352 may be provided as a second power terminal or a ground terminal. The third pad 353 may be provided as a current or voltage detection terminal. The fourth pad 354 may be provided as a terminal for reading an identification code embedded in the battery. The first pad 351 connecting the VBAT signal and the second pad 352 connecting the GND signal may be disposed around the fixing member 340 to ensure stability of connection. The first pad 351 connecting the VBAT signal and the second pad 352 connecting the GND signal may be disposed to surround the at least one first hole 322 through which the fixing member 340 penetrates to ensure stability of connection. For example, the first pad 351 connecting the VBAT signal may be disposed to surround the 1-1 hole 322a. For example, the second pad 352 connecting the GND signal may be disposed to surround the 1-2 hole 322b. For example, the third pad 353 connecting the P-Sense signal and the fourth pad 354 connecting the ID signal may be disposed between the 1-1 hole 322a and the 1-2 hole 322b. The number of the at least one pad 350 and signal lines may be increased or decreased according to the purpose of use.

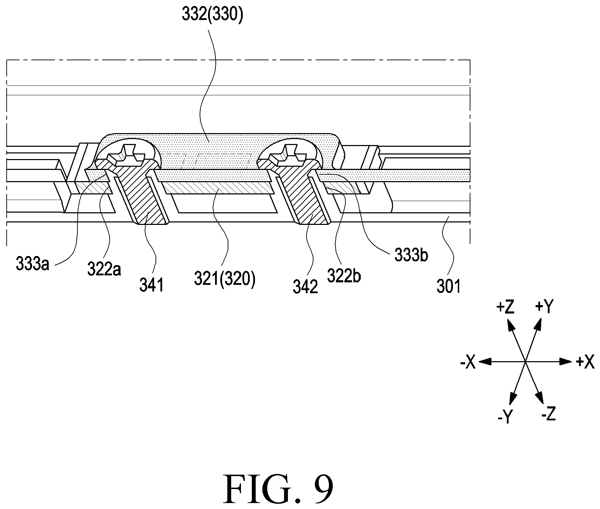

FIG. 8 is a view illustrating an assembled state of a circuit board, a battery pack, and a housing viewed from above according to embodiments of the disclosure. FIG. 9 is a cross-sectional view of FIG. 8 taken along line A-A' according to an embodiment of the disclosure.

Referring to FIGS. 8 and 9, an electronic device 101 may include a housing 301, a battery pack 302 disposed in the housing 301, a circuit board 330, and at least one fixing member 340 connecting and/or fixing the circuit board 330 and the battery pack 302. The configuration of the housing 301, the battery pack 302, the circuit board 330, and the fixing member 340 of FIGS. 8 and 9 may be entirely or partially identical to the configuration of the housing 301, the battery pack 302, the circuit board 330, and the fixing member 340 of FIG. 7. The embodiment of FIGS. 8 and 9 may be partially combined with the embodiment of FIG. 7.

According to an embodiment, the circuit board 330 may be disposed in the housing 301. According to an embodiment, the battery pack 302 may be disposed on a first supporting member (e.g., the first supporting member 311 of FIG. 3). According to an embodiment, the circuit board 330 may be disposed such that at least part of the battery protection circuit module 320 is disposed in an upper direction (+Y axis direction). According to an embodiment, the circuit board 330 may be disposed such that at least part thereof is disposed in an upper direction (+Y axis direction) of the battery protection circuit module 320 and at least part thereof overlaps with the battery protection circuit module 320. For example, the circuit board 330 may include a first area 331 disposed in an upper direction (+Y axis direction) of the battery protection circuit module 320 and a second area 332 extending from the first area 331 in a lower direction (-Y axis direction) and disposed to overlap with the battery protection circuit module 320. According to an embodiment, the second area 332 of the circuit board 330 may be an area disposed to overlap with at least part of the battery protection circuit module 320 and protruding in a lower direction (-Y axis direction). For example, the circuit board 330 may have an " 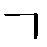 " shape or a " 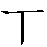 " shape. According to an embodiment, the second area 332 may be in contact with the battery protection circuit module 320. For example, the second area 332 may be disposed to overlap with at least one first connecting portion 321 of the battery protection circuit module 320.

According to an embodiment, the circuit board 330 may include at least one second hole 333 corresponding to the at least one first hole 322. According to an embodiment, the circuit board 330 may be directly electrically connected to the battery protection circuit module 320 through the at least one second hole 333. According to an embodiment, the at least one second hole 333 may be disposed in the second area 332. The at least one second hole 333 may be a configuration for stable coupling between the at least one pad 350 formed on the circuit board 330 and the battery protection circuit module 320, and for fixing the position of the circuit board 330. For example, the second hole 333 may include a 2-1 hole 333a located in a relatively left direction (-X axis direction) and a 2-2 hole 333b located in a right direction (+X axis direction) of the 2-1 hole 333a. For example, the 2-1 hole 333a and the 2-2 hole 333b may be arranged side by side. For example, the at least one second hole 333 may be disposed to overlap with at least part of the battery protection circuit module 320. For example, the at least one second hole 333 may be disposed to overlap with the at least one first hole 322 of the battery protection circuit module 320. However, the size and number of the at least one second hole 333 are not limited by the above embodiment and may be variously modified.

According to an embodiment, the electronic device 101 may include at least one fixing member 340 connecting and/or fixing the circuit board 330 and the battery pack 302. According to an embodiment, the at least one fixing member 340 may physically and/or electrically connect the circuit board 330 and the battery protection circuit module 320.

According to an embodiment, the at least one fixing member 340 may be configured to penetrate through the at least one first hole 322 and the at least one second hole 333. For example, the at least one fixing member 340 may include a first fixing member 341 configured to be coupled in a relatively left direction (-X axis direction) and a second fixing member 342 configured to be coupled in a right direction (+X axis direction) of the first fixing member 341. For example, the first fixing member 341 may be configured to penetrate through the 1-1 hole 322a and the 2-1 hole 333a. For example, the second fixing member 342 may be configured to penetrate through the 1-2 hole 322b and the 2-2 hole 333b. For example, the first fixing member 341 and the second fixing member 342 may be arranged side by side. For example, the fixing member 340 may be any one of a screw and a clip (e.g., c-clip). For example, when the fixing member 340 is a screw, accessory materials such as a connector and a clip may be unnecessary.

According to an embodiment, referring to FIG. 9, a process of assembling the printed circuit board 330 and the battery pack 302 to the housing 301 may be described. The process may proceed in an order of a process of disposing the battery pack 302 in the housing 301, a process of disposing the circuit board 330 in the housing 301 such that the at least one first hole 322 of the battery pack 302 and the at least one second hole 333 are aligned, and a process of fastening the fixing member 340 to the at least one first hole 322 and the at least one second hole 333. By fastening the fixing member 340 to the at least one first hole 322 and the at least one second hole 333, the housing 301, the battery pack 302, and the circuit board 330 may be fixed at once.

An electronic device according to an embodiment of the disclosure may include a housing 301, a battery pack 302 disposed in the housing and including a battery cell 310 and a battery protection circuit module (PCM) 320 including a first connecting portion 321 disposed to be in contact with a surface of the battery cell, wherein at least one first hole 322 is formed atthe first connecting portion, a circuit board 330 disposed to overlap with at least part of the battery protection circuit module, wherein at least one second hole 333 is formed at the circuit board, and at least one fixing member 340 configured to penetrate through the at least one first hole and the at least one second hole to fix the battery protection circuit module and the circuit board to the housing.

According to an embodiment, the circuit board may include a first area 331 disposed in a first direction of the battery protection circuit module and a second area extending from the first area in a second direction opposite to the first direction and disposed to overlap with the battery protection circuit module.

According to an embodiment, the at least one second hole may be formed at the second area and configured to face the at least one first hole, and the second area may be configured to face the first connecting portion.

According to an embodiment, the battery protection circuit module may be disposed in a first direction (upper direction, +Y axis direction) of the battery cell.

According to an embodiment, the circuit board may be positioned in a first direction (upper direction, +Y axis direction) of the battery protection circuit module, and the first connecting portion may protrude from an upper surface of the battery protection circuit module in the first direction (upper direction, +Y axis direction).

According to an embodiment, the housing may include a partition 301a protruded from a surface of the housing and disposed to surround at least part of a side of the battery pack.

According to an embodiment, the at least one first hole may include a 1-1 hole 322a and a 1-2 hole 322b disposed to be spaced apart from the 1-1 hole, and the at least one second hole may include a 2-1 hole 333a corresponding to the 1-1 hole and a 2-2 hole 333b corresponding to the 1-2 hole.

According to an embodiment, the at least one fixing member may include a first fixing member 341 configured to penetrate through the 1-1 hole and the 2-1 hole, and a second fixing member 342 configured to penetrate through the 1-2 hole and the 2-2 hole.

According to an embodiment, the fixing member may be any one of a screw and a clip.

According to an embodiment, the first connecting portion may include at least one pad 350 disposed on a surface of the first connecting portion facing the circuit board.

According to an embodiment, the at least one pad may include at least one of a first pad 351 provided as a first power terminal, a second pad 352 provided as a second power terminal or a ground terminal, a third pad 353 provided as a current or voltage detection terminal, or a fourth pad 354 provided as a terminal for reading an identification code embedded in the battery.

According to an embodiment, the first pad and the second pad may be disposedto surround the at least one first hole.

According to an embodiment, the third pad and the fourth pad may be disposed between the 1-1 hole and the 1-2 hole.

According to an embodiment, the battery protection circuit module may include a battery protection circuit and a board on which the battery protection circuit is mounted, and at least a portion of the first connecting portion may be electrically connected to the battery protection circuit.

An electronic device according to an embodiment of the disclosure may include a housing 301, a battery pack 302 disposed in the housing and including a battery cell 310 and a battery protection circuit module (PCM) 320 including a first connecting portion 321 disposed to be in contact with a surface of the battery cell, wherein at least one first hole 322 is formed at the first connecting portion, a circuit board 330 disposed to overlap with at least part of the battery protection circuit module, wherein at least one second hole 333 is formed at the circuit board, and at least one fixing member configured to penetrate through the at least one first hole and the at least one second hole to fix the battery protection circuit module and the circuit board to the housing. The first connecting portion may include at least one pad 350 disposed on a surface of the first connecting portion in contact with the circuit board and electrically connected to at least part of the circuit board.

According to an embodiment, the circuit board may include a first area 331 disposed in a first direction of the battery protection circuit module and a second area extending from the first area in a second direction opposite to the first direction and disposed to overlap with the battery protection circuit module.

According to an embodiment, the at least one second hole may be formed at the second area and configured to face the at least one first hole, and the second area may be configured to face the first connecting portion.

According to an embodiment, the at least one pad may include at least one of a first pad 351 provided as a first power terminal, a second pad 352 provided as a second power terminal or a ground terminal, a third pad 353 provided as a current or voltage detection terminal, and a fourth pad 354 provided as a terminal for reading an identification code embedded in the battery.

A battery pack according to an embodiment of the disclosure may include a battery cell and a battery protection circuit module (PCM) 320 including a first connecting portion 321 disposed to be in contact with a surface of the battery cell, wherein at least one first hole 322 is formed at the first connecting portion 321. The first connecting portion may include at least one pad 350 electrically connected to at least part of the circuit board.

Technical problems to be achieved in this document are not limited to the above-mentioned technical problems, and other technical problems not mentioned may be clearly understood by those of ordinary skill in the art belonging to this document from the following description.

When assembling the battery pack 302 to the housing 301, a double-sided adhesive tape may be used. For example, for battery assembly, a specific ratio or more of the battery tape area may be set on an attachment surface of the battery, and after assembling the battery to a portable terminal, a process of pressing using a pressing machine may be performed. For example, since a gap with surrounding mechanical components must be set to attach the battery to the housing 301, an attachment jig may be used for accurate attachment, but since it is a manual process, an error in the attachment position may occur. It may be difficult to easily disassemble and/or reattach the battery pack 302 from the housing 301.

In general, the battery protection circuit module 320 (PCM) may be connected to the housing 301 using a flexible printed circuit board 330 (FPCB) and a connector. A crack may occur in the flexible printed circuit board 330 (FPCB) in a process of bending the flexible printed circuit board 330 (FPCB), which may lead to a battery pack 302 defect or a power defect. Also, when the position is not accurately aligned in a process of fastening a connector, a connector terminal may be crushed, or a defect in the battery or a main printed circuit board 330 of the electronic device 101 may occur.

The battery protection circuit module 320 according to an embodiment disclosed in this document may implement improvement in an assembly method and resistance of the battery protection circuit module 320 by not using the flexible printed circuit board 330 (FPCB) and a connector while maintaining the same circuit and function, and performance as a general battery protection circuit module 320.

According to an embodiment disclosed in this document, the battery protection circuit module 320 may be connected to the circuit board 330 through the first connecting portion 321 without using the flexible printed circuit board 330 (FPCB) and/or a connector, thereby solving a crack occurring when bending the flexible printed circuit board 330 (FPCB) in the manufacturing process, and a product defect problem occurring due to inaccurate positioning when fastening a connector. By removing a resistance (DCR) occupied by the flexible printed circuit board 330 (FPCB), charging time may be shortened by approximately 5 minutes, and heat dissipation performance of the battery protection circuit module 320 may be improved.

An embodiment disclosed in this document may implement assembly of the battery and the housing 301 of the electronic device 101 and the circuit board 330 through automation. According to an embodiment disclosed in this document, by mounting the battery on the housing 301, disposing the circuit board 330, and coupling the fixing member 340 (e.g., screw), the housing 301, the battery, and the circuit board 330 may be fixed at once. Since only simple stacking is performed, automation implementation is possible, and since no separate operation is required even when disassembling the housing 301 and the battery, battery replacement may be easy.

However, the problems to be solved in the disclosure are not limited to the above-mentioned problems, and may be variously extended without departing from the spirit and scope of the present invention.

## Claims

1. An electronic device comprising:
a housing (301);
a battery pack (302) disposed in the housing and including a battery cell (310), and a battery protection circuit module (320) disposed to be in contact with a surface of the battery cell and including a first connecting portion (321), wherein at least one first hole (322) is formed at the first connecting portion;
a circuit board (330) disposed to overlap with at least part of the battery protection circuit module, wherein at least one second hole (333) is formed at the circuit board (330); and
at least one fixing member (340) configured to penetrate through the at least one first hole and the at least one second hole to fix the battery protection circuit module and the circuit board to the housing.

2. The electronic device of claim 1,
wherein the circuit board includes a first area (331) disposed in a first direction (+Y axis direction) of the battery protection circuit module and a second area (332) extending from the first area in a second direction (-Y axis direction) opposite to the first direction and disposed to overlap with the battery protection circuit module.

3. The electronic device of claim 2,
wherein the at least one second hole is formed at the second area and is configured to face the at least one first hole, and wherein the second area is configured to face the first connecting portion.

4. The electronic device of claim 2 or 3,
wherein the battery protection circuit module is positioned in the first direction of the battery cell.

5. The electronic device of any one of claims 1 to 4,
wherein the circuit board is positioned in the first direction of the battery protection circuit module, and
wherein the first connecting portion is protruded from the battery protection circuit module in the first direction.

6. The electronic device of any one of claims 1 to 5,
wherein the housing includes a partition (301a) protruded from a surface of the housing and disposed to surround at least part of a side of the battery pack.

7. The electronic device according to any one of claims 1 to 6,
wherein the at least one first hole includes a 1-1 hole (322a) and a 1-2 hole (322b) disposed to be spaced apart from the 1-1 hole (322a), and
wherein the at least one second hole includes a 2-1 hole (333a) corresponding to the 1-1 hole (322a) and a 2-2 hole (333b) corresponding to the 1-2 hole (322b).

8. The electronic device of claim 7,
wherein the at least one fixing member includes a first fixing member (341) configured to penetrate through the 1-1 hole and the 2-1 hole, and a second fixing member (342) configured to penetrate through the 1-2 hole and the 2-2 hole.

9. The electronic device of any one of claims 6 to 8,
wherein the first connecting portion includes at least one pad (350) which is disposed on a surface of the first connecting portion facing the circuit board.

10. The electronic device of claim 9,
wherein the at least one pad includes at least one of a first pad (351) provided as a first power terminal, a second pad (352) provided as a second power terminal or a ground terminal, a third pad (353) provided as a current or voltage detection terminal, or a fourth pad (354) provided as a terminal for reading an identification code embedded in the battery.

11. The electronic device of claim 10,
wherein the first pad and the second pad are disposed to surround the at least one first hole.

12. The electronic device of claim 10 or 11,
wherein the third pad and the fourth pad are disposed between the 1-1 hole and the 1-2 hole.

13. The electronic device of any one of claims 1 to 12,
wherein the battery protection circuit module includes a battery protection circuit and a board on which the battery protection circuit is mounted,
wherein at least a portion of the first connecting portion is electrically connected to the battery protection circuit.

14. The electronic device of any one of claims 1 to 13,
wherein a thickness (d3) of the first connecting portion is less than a thickness (d2) of the battery protection circuit module.

15. An electronic device comprising:
a housing (301);
a battery pack (302) disposed in the housing and including a battery cell (310), and a battery protection circuit module (protective circuit module (PCM)) (320) disposed to be in contact with a surface of the battery cell and including a first connecting portion (321), wherein at least one first hole (322) is formed at the first connecting portion;
a circuit board (330) disposed to overlap with at least part of the battery protection circuit module, wherein at least one second hole (333) is formed at the circuit board (330); and
at least one fixing member (340) configured to penetrate through the at least one first hole and the at least one second hole to fix the battery protection circuit module and the circuit board to the housing,
wherein the first connecting portion includes at least one pad (350) disposed on a surface of the first connecting portion in contact with the circuit board and electrically connected to at least part of the circuit board.
